(19)

Europäisches
Patentamt
European
Patent Office
Office européen
des brevets

(11) **EP 1 494 351 B1**

(12) **EUROPEAN PATENT SPECIFICATION**

(45) Date of publication and mention
of the grant of the patent:
**03.03.2010 Bulletin 2010/09**

(51) Int Cl.:
**H03F 3/45** *(2006.01)*    **H03F 1/32** *(2006.01)*

(21) Application number: **03425430.0**

(22) Date of filing: **30.06.2003**

(54) **Method and corresponding circuit structure to correlate the transconductance of transistors of different type**

Verfahren und entsprechende Schaltungsanordnung zum Korrelieren von Transkonduktanz von Transistoren unterschiedlichen Typs

Procédé et circuit correspondant permettant de mettre en corrélation la transconductance de différents types de transistors

(84) Designated Contracting States:
**DE FR GB IT**

(43) Date of publication of application:
**05.01.2005 Bulletin 2005/01**

(73) Proprietor: **STMicroelectronics S.r.l.**
**20041 Agrate Brianza (Milano) (IT)**

(72) Inventors:
• **Filoramo, Pietro**
**96100 Siracusa (IT)**
• **Cali, Giovanni**
**95125 Catania (IT)**

(74) Representative: **Zambardino, Umberto**
**Botti & Ferrari S.r.l.**
**Via Locatelli, 5**
**20124 Milano (IT)**

(56) References cited:
**EP-A- 0 597 420**    **GB-A- 2 369 508**
**US-A- 6 124 760**    **US-B1- 6 531 919**

• **REZZI F ET AL: "A 3V PSEUDO-DIFFERENTIAL TRANSCONDUCTOR WITH INTRINSIC REJECTION OFTHE COMMON-MODE INPUT SIGNAL" PROCEEDINGS OF THE MIDWEST SYMPOSIUM ON CIRCUITS AND SYSTEMS. LAFAYETTE, AUG. 3 - 5, 1994, NEW YORK, IEEE, US, vol. 1 SYMP. 37, 3 August 1994 (1994-08-03), pages 85-88, XP000531982 ISBN: 0-7803-2429-3**

**Description**

Field of application

The present invention relates to a method and relevant circuit structure to correlate the transconductance value of transistors of different type, independently from process tolerances and temperature.

Prior art

As it is well known to the skilled in the art, under low signal conditions, the output current $i_{OUT}$ of a transistor is proportional to the input voltages $v_{in}$ applied thereto by a proportionality coefficient called transconductance $g_m$.

The law of this transconductance variation with temperature and process parameters determining the value thereof is generally function of the chosen transistor type and of the particular integration process. It results that different types of transistors have transconductances being uncorrelated to each other and variable with respect to temperature each according to convenient laws.

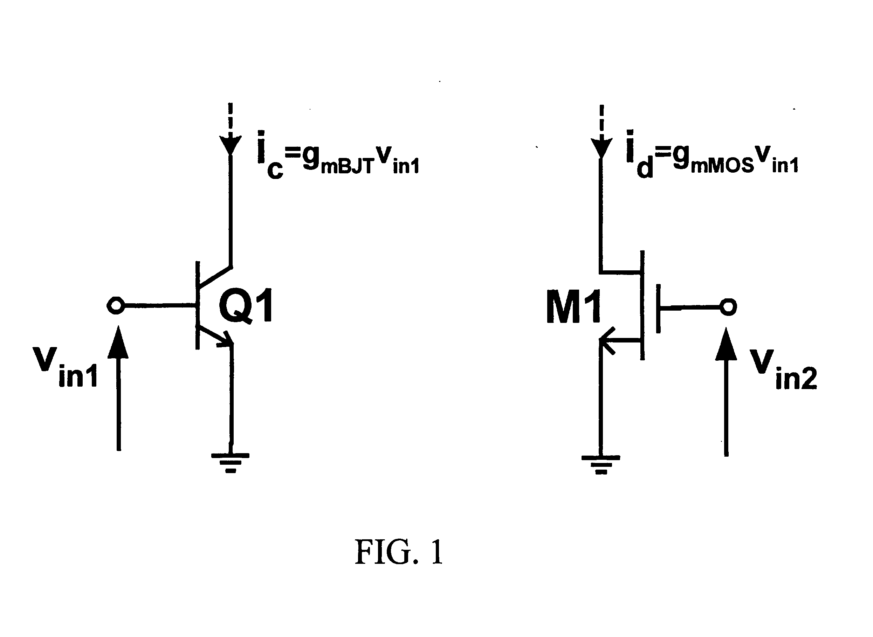

For example, a bipolar NPN transistor and a NMOS transistor are shown with reference to figure 1, whose input-output relation under low signal conditions are respectively:

$$i_c = g_{mBJT} \cdot V_{in1} \tag{1}$$

$$i_d = g_{mMOS} \cdot V_{in2} \tag{2}$$

the respective transconductance expressions are:

$$g_{mBJT} \equiv \frac{\alpha \cdot I_E}{v_T} \tag{3}$$

$$g_{mMOS} = 2\sqrt{K_n \cdot \frac{W}{L} \cdot I_D} \tag{4}$$

where

$\alpha$ is the current gain of the common-base-configured bipolar transistor

$v_T$ is the thermal voltage

W/L is the form factor of MOS transistors

$K_n$ is a process constant of the NMOS transistor being proportional to the mobility $\mu n$ and to the oxide specific capacity $C_{ox}$

$I_E$ is the emitter bias current of the bipolar transistor Q1

$I_D$ is the bias current of the MOS transistor M1

From a comparison between the expressions (3) and (4) it is evident that the transconductances of the two types of transistors depend on different process parameters and they also have different laws of variation with temperature and they are thus generally uncorrelated.

At present, the prior art does not provide any effective solution to correlate to each other the transconductance values of different types of transistors, i.e. to achieve a relation like the following one being mediated by a proportionality coefficient γ.

$$G_{m\_TYPE1} = \gamma \cdot g_{m\_TYPE2}$$

Also known from the UK Patent Application published under No. GB 2 369 508 in the name of Zarlink Semiconductor Limited is a Low-noise low-distortion amplifier. In particular, the disclosed amplifier comprises a first, a second and a third transconductance stages, suitably connected in order to provide a double compensation. In essence, the second stage has inputs connected to the outputs of the first stage and outputs connected across a resistor to current feedback inputs of the first stage so as to provide a negative feedback which improves the linearity of the amplifier as a whole, without increasing its noise, while the first and third stages provide feedforward distortion cancelling further enhancing the linearity of the amplifier.

The technical problem underlying the present invention is to provide a method for correlating the transconductances of at least two different types of transistors, independently from process tolerances and temperature and by means of a proportionality coefficient.

Summary of the invention

The solution idea underlying the present invention is to use a circuit structure comprising a couple of differential cells, each cell being formed by a differential couple of transistors of the same type, interconnected to each other by means of a circuit portion responsible for calculating the error signal between the difference of respective differential currents, using then this error signal, in case conveniently amplified, to bias one of the two differential couples and simultaneously drive the same circuit structure output.

A correlation between the respective transconductances of the different types of transistors of the first and second cell is therefore obtained, which is totally independent from process tolerances and temperature.

On the basis of this solution idea the technical problem is solved by a method as previously indicated and defined in claim 1.

The invention also relates to a circuit structure defined in claim 5 and the followings.

The features and advantages of the method and circuit structure according to the invention will be apparent from the following description of an embodiment thereof given by way of non-limiting example with reference to the attached drawings.

Brief description of the drawings

- Figure 1 schematically shows the comparison between a bipolar NPN transistor and a NMOS transistor and the relevant voltages and currents;

- Figure 2 schematically shows a circuit structure manufactured according to the invention to correlate the transconductances of at least two different types of transistors;

- Figure 3 schematically shows in greater circuit detail a possible embodiment of the example of figure 2;

- Figure 4 schematically shows a MOS transistor amplifier circuit structure, in BICMOS technology, with compensation of the variations with the temperature of the voltage gain according to the prior art;

- Figure 5 schematically shows a circuit structure according to the invention being output-connected to a MOS transistor amplifier;

- Figure 6 schematically shows a variable gain amplifier allowing, in association with a circuit structure according to the invention, the amplifier output dynamic range to remain constant when the process and the temperature vary;

- Figure 7 schematically shows a detail of the amplifier of figure 6;

- Figure 8 schematically shows a circuit structure according to the invention being output-connected to a variable gain amplifier;

- Figure 9 schematically shows a detail of the embodiment of figure 8.

Detailed description

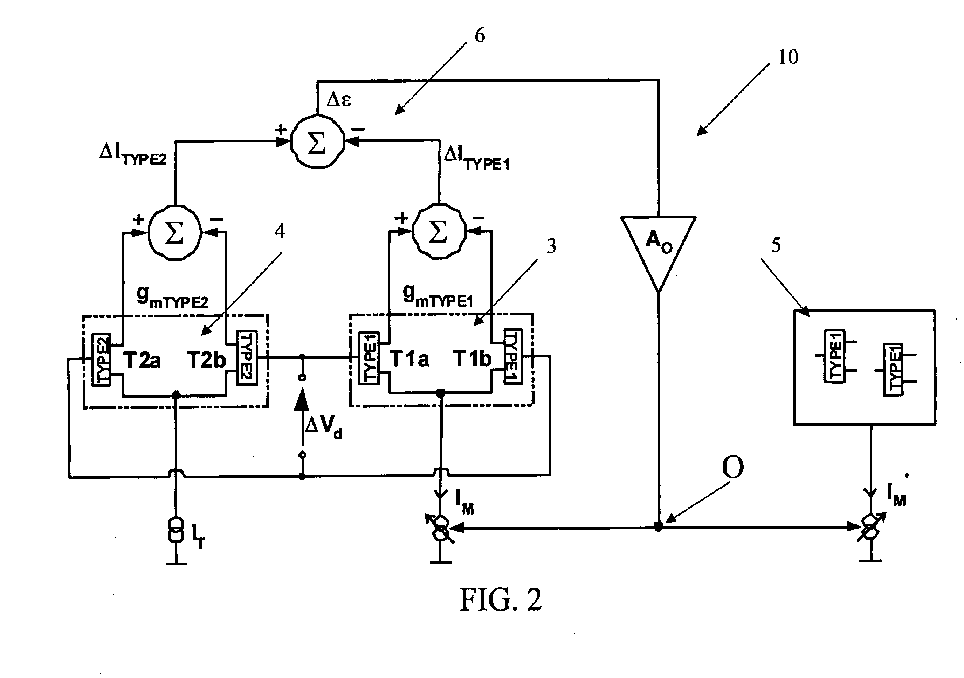

With reference to these drawings, and particularly to the example of figure 2, a circuit structure comprising a first and a second differential cell 3, 4, which are connected to each other according to the present invention to correlate the transconductances of at least two different types of transistors, is globally and schematically indicated with 10.

The first cell 3 comprises a differential couple of a first type 1 (TYPE1) of transistors T1a, T1b, while the second cell 4 comprises a differential couple of a second type 2 (TYPE2) of transistors T2a, T2b.

Cells 3 and 4 are interconnected by means of a current mirror circuit portion 6, comprised in the structure 10, responsible for drawing a current error signal $\Delta\varepsilon$ related to the difference of the two cell differential currents, as it will be more apparent in the following description. This current error signal $\Delta s$ is applied, in an amplified way, to the output node O of structure 10. This current error signal is thus used to bias the first differential cell in order to obtain a feedback inside structure 10.

According to the diagram of figure 2, the transconductances of transistors of different type are correlated to each other independently from process tolerances and temperature, by a proportionality coefficient. In other words, for said two general types of transistors, type 1 and type 2, the following correlation is to be ensured:

$$gm\_TYPE1 = \gamma.gm\_TYPE2$$

being $\gamma$ a proportionality coefficient drawn by the ratio between homologous quantities and thus independent both from the temperature and from process tolerances.

In figure 2 it can be seen that the first differential cell 3 is connected towards a first potential reference, for example a signal ground GND, by means of a current driven generator $I_M$, whose driving terminal is connected to the output node O.

Supposing to apply to the second differential couple 4 of transistors of type 2, biased by a tail current $I_T$, a constant differential voltage $\Delta V_d$ being sufficiently small as to consider the low signal approximation valid. Under such conditions the differential current $\Delta I_{TYPE2}$ of the second differential couple of transistors of type 2 is:

$$\Delta I_{TYPE2} \cong g_{mTYPE2}\Delta V_d \qquad\qquad (5)$$

Similarly, by applying the same voltage difference $\Delta V_d$ to the first differential couple 3 of type 1, the respective differential output current $\Delta I_{TYPE1}$ is:

$$\Delta I_{TYPE1} \cong g_{mTYPE1}\Delta V_d \qquad\qquad (6)$$

Therefore, being $\Delta\varepsilon$ the current error signal related to the difference of the two differential currents and $\psi$ the proportionality coefficient of the input-output relation of the current driven generator $I_M$, it results:

$$i_M = \psi.A_0.\Delta\varepsilon = \psi.A_0.(\Delta I_{TYPE2} - \Delta I_{TYPE1}) \qquad\qquad (7)$$

from which, by replacing (5) and (6) it results:

$$i_M = \psi.A_0.(g_{mTYPE2} - g_{mTYPE1}).\Delta V_d \qquad\qquad (8)$$

By virtue of the low signal approximation, it can be assumed that the dependence law of the transconductance $g_{mTYPE1}$ of type 1 from the low signal current $i_M$ is linear and, thus, being p the proportionality coefficient, it results:

$$g_{mTYPE1} = \rho \cdot i_M \tag{9}$$

from which, by replacing (8) it results:

$$g_{mTYPE1} = \rho \cdot \psi \cdot A_0 \cdot (g_{mTYPE2} - g_{mTYPE1}) \cdot \Delta V_d \tag{10}$$

from which finally, making the transconductance of type 1 explicit, it results:

$$g_{mTYPE1} = \frac{\rho \cdot \psi \cdot A_0 \cdot \Delta V_d}{1 + \rho \cdot \psi \cdot A_0 \cdot \Delta V_d} g_{mTYPE2} \tag{11}$$

By manufacturing the error amplifier so that the gain Ao is such as to make the product $\rho \cdot \psi \cdot A_o \cdot \Delta V_d$ sufficiently high, then the transconductance of the differential couple 3 of type 1 will tend to equal the transconductance of the differential couple 2 of type 2, i.e.:

$$g_{m\_TYPE1} \cong g_{mTYPE2} \tag{12}$$

In the common application the value of A0 is determined in order to ensure the desired static precision $\frac{\Delta g_m}{g_m}$, according to the following relation:

$$\frac{\Delta g_m}{g_m} = \frac{1}{\rho \cdot \psi \cdot A_0 \cdot \Delta V_d} \tag{13}$$

Being the condition (12) between the differential couples 4, 3 of type 2 and of type 1 satisfied, the tail current $I_M{}'$, obtained from the tail current $I_M$ by means of a current mirror ratio, can be used to bias general circuit blocks comprising transistors of type 1 and generally indicated by block 5. Between the transistors of the general block 5 of type 1 and those of type 2 the following relation is satisfied:

$$g_{m\_TYPE1} \cong \gamma \cdot g_{mTYPE2} \tag{14}$$

whose proportionality coefficient will depend only on the mirror ratio $\frac{I_M{}'}{I_M}$ and on type 1 transistor size ratio.

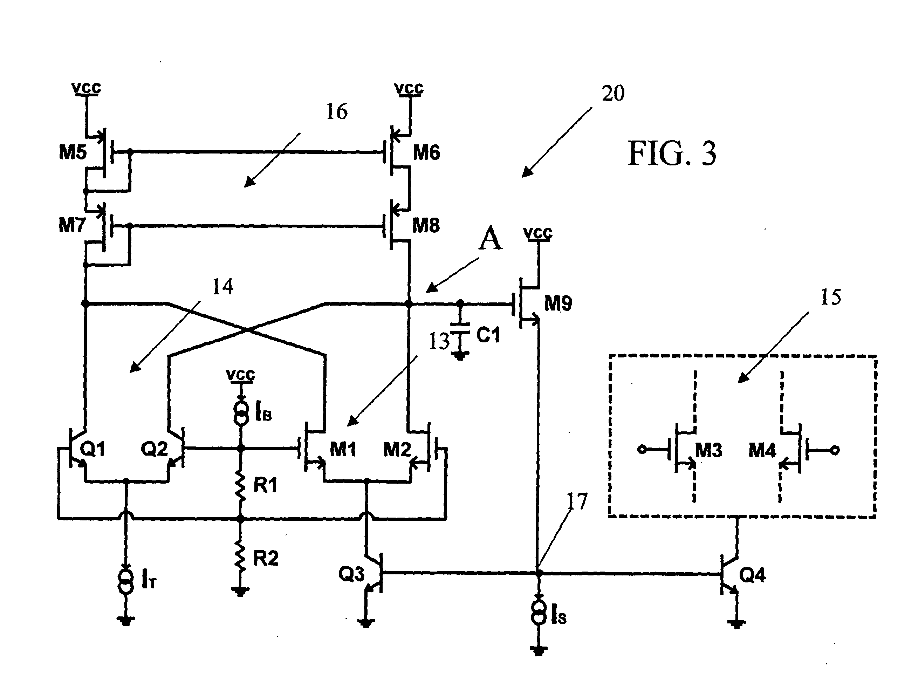

A possible BiCMOS technology implementation of the circuit structure of figure 2 is shown in figure 3 with the numeral 20.
In this embodiment the MOS transistor transconductance has been correlated to the bipolar transistor one.
In this example a first MOS transistor differential cell 13 is connected to a second bipolar transistor differential cell 14 by means of a current mirror circuit portion 16 being cascode-connected and comprising MOS transistors M5-M8. A bipolar transistor Q3 operates as current driven generator for the first differential cell 13.
It is however possible that the circuit portion 16 is manufactured with bipolar transistors. Similarly, also the current driven generator, manufactured by means of the bipolar transistor Q3, can be manufactured by means of a MOS transistor.

The circuit operation is the following. The bipolar transistor differential couple 14 is biased by a tail current $I_T$, the value of the respective transconductance is thus $g_{mBJT} \equiv \dfrac{\alpha \cdot I_T}{2 \cdot v_T}$.

Each input differential couple is biased by the common mode voltage $I_B.R_2$ and it is excited by the constant differential voltage $\Delta V_d = I_B.R_1$. The latter is fixed sufficiently low ($\Delta V_d \ll 2v_T$) as to consider the following low signal approximation valid:

$$\Delta I_{BJT} = \alpha \cdot I_T \cdot \tanh\left(\frac{\Delta V_d}{2v_T}\right) \cong g_{mBJT} \cdot \Delta V_d \qquad (15)$$

where the differential current of the second bipolar transistor differential couple 14 has been indicated with $\Delta I_{BJT}$. Under such conditions, similarly for the first MOS transistor differential couple 13, it results:

$$\Delta I_{MOS} \cong g_{mMOS} \cdot \Delta V_d \qquad (16)$$

The cascode M5-M8 current mirror 16 provides to perform both the difference between the two differential currents $\Delta I_{BJT}$ and $\Delta I_{MOS}$ and the current-voltage conversion through the dynamic resistance in the interconnection node A between respective conduction terminals of transistors M2 and M8, thus producing an "error signal" $\Delta v_\varepsilon$. The use of a cascode mirror 16 with respect to a simple mirror advantageously ensures a higher accuracy and reduces considerably the systematic equivalent input offset. Therefore the so-obtained error signal $\Delta v_\varepsilon$ has the following expression:

$$\Delta v_\varepsilon = (\Delta I_{BJT} - \Delta I_{MOS}).r_{OUT} \cong (g_{mBJT} - g_{mMOS}).r_{OUT}.\Delta V_d \qquad (17)$$

A transistor M9, located at the output of the structure 20 in follower configuration, provides again the same error signal $\Delta v_\varepsilon$ at the output node 17 thereof coinciding with the transistor Q3 base. Therefore, being $g_{m3}$ the transistor Q3 transconductance, it will result:

$$g_{mMOS} = \xi.g_{m3}.\Delta v_\varepsilon \qquad (18)$$

being $\xi$ the proportionality coefficient of the current-transconductance relation achieved though the linearization of the expression (4), i.e.:

$$g_{mMOS} = \xi.i_{c3} \qquad (19)$$

Combining the (17) and the (18) a similar relation to the one seen in general terms is obtained:

$$g_{mMOS} = g_{mBJT} \cdot \frac{\xi \cdot g_{m3} \cdot r_{OUT} \cdot \Delta V_d}{1 + \xi \cdot g_{m3} \cdot r_{OUT} \cdot \Delta V_d} \qquad (20)$$

Therefore for sufficiently high gain values $A_0 = g_{m3} \cdot r_{OUT}$ the transconductance of the MOS differential couple tends to the one of the bipolar differential couple, i.e.

$$g_{mMOS} \cong g_{mBJT} \qquad (21)$$

A current driven generator Q4, obtained in this embodiment by means of a bipolar transistor, connects the output 17 to a group 15 of MOS transistors which indicates a general MOS transistor circuit portion.

When the tail current generator Q3 is manufactured by means of a MOS transistor, also the tail generator Q4 should be manufactured by means of a MOS transistor in order to keep the mirror factor between the tail generator currents unchanged.

The current $I_{C4}$ of the transistor Q4, obtained from the bias current $I_{c3}$ through the ratio of the areas of transistors Q4 and Q3, can thus be used to bias circuits 15 using NMOS transistors. The transconductance $g_{mMos}\pm$ of these NMOS transistors will be therefore equal to the one of the cell 14 comprising the couple of bipolar transistors Q1-Q2, conveniently reduced by the ratio of the current mirror factor formed by the transistors Q3, Q4, this mirror factor being equal to the ratio of the emitter areas of these transistors Q4 and Q3 and of the ratio of NMOS transistor form factors, i.e.:

$$g_{mMOS} \cong \gamma \cdot g_{mBJT} \qquad (22)$$

A possible use of the invention suggested is the generation of a bias current effective to keep the voltage gain of MOS transistor amplifiers 15 having a gain of the $g_{mMOS}.R_L$ type in BICMOS technology applications constant when the temperature varies.

Generally, MOS transistor amplifiers, having a gain of the $g_{mMos}.R_L$ type, are biased by means of a current $I_{BIAS}$ drawn as ratio between the difference of $V_{GS}$ of two MOS transistors and an allocated resistance having the same temperature variation coefficient of the load resistance, i.e.:

$$I_{BIAS} = \frac{\Delta V_{GS}}{R*} \qquad (23)$$

where

$$\frac{1}{T}\frac{\partial}{\partial T}R* \equiv \frac{1}{T}\frac{\partial}{\partial T}R_L$$

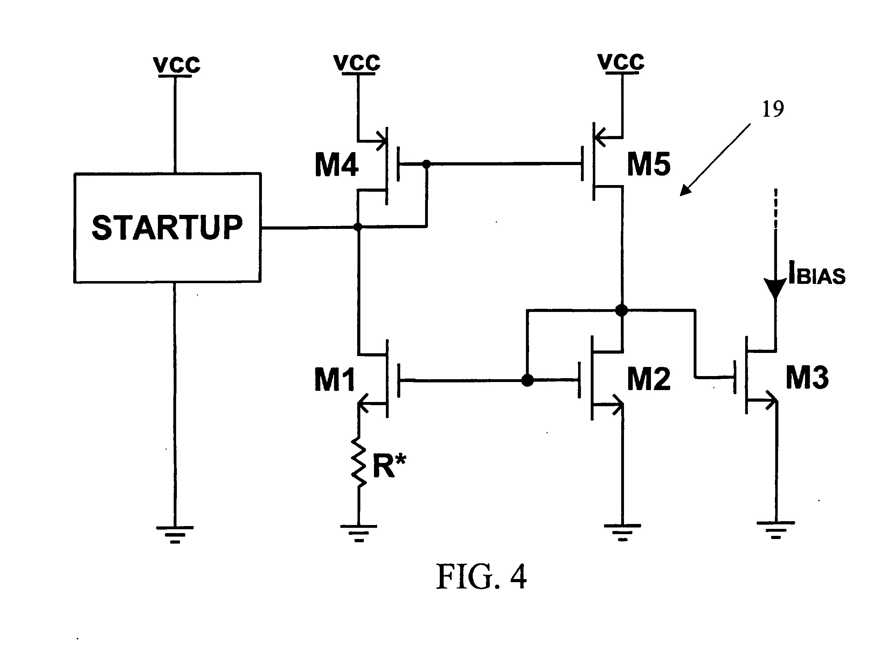

Through simple mathematical steps it can be demonstrated that the law (23) offsets in temperature both the transconductance $g_{mMos}$ variation and the load resistance $R_L$ variation, and thus it offsets temperature voltage gain variations. By way of example figure 4 shows a possible bias circuit 19 implementing said law.

In a dual way, for bipolar transistor circuits, the voltage gain is offset in temperature by circuits being similar to the one of figure 4 producing a bias current which is proportional to the absolute temperature (PTAT).

Usually in BICMOS technology integrated circuits, the two typologies of MOS transistor and bipolar transistor amplifiers use each a convenient bias circuit to offset gain variations in temperature.

On the contrary, according to the present invention, by using a compensation circuit structure, it is possible to use a single current bias reference for both typologies of amplifiers.

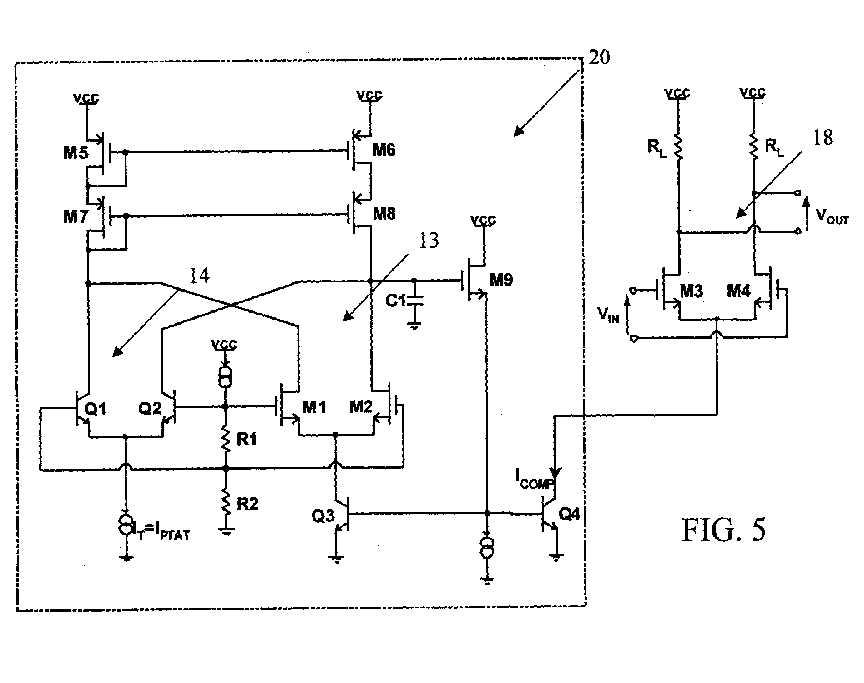

For example, with reference to figure 5, since the relation (22) applies for any process and temperature condition, it is possible to bias the bipolar differential couple 14 Q1-Q2 with a tail current (current generator IT) drawn from a PTAT bias circuit, and to use thus the output current of the transistor Q4 collector to bias MOS transistor amplifiers 18 having a $g_{mMOS.RL}$ gain, as indicated in the figure. The compensation in temperature of the bipolar transistor couple transconductance ensures therefore for the (22) that also the transconductance of MOS transistors is constant when the temperature varies.

The use of the circuit structure according to the invention is particularly advantageous in biasing circuits having an extremely limited current consumption and those using, for accuracy reasons, external reference resistances. In fact, in the first case, by using a single current reference for both typologies of transistors, the silicon area occupation is considerably reduced, halving the area commonly dedicated to the resistances of current references R*. In the second case, the use of said bias system allows two temperature-constant-gain current references to be obtained starting from a single external reference, to the advantage of the number of components used and of the whole application cost.

In a dual way, the method provided can be naturally applied to bias bipolar differential couples starting from a current reference for MOS transistors amplifiers with the same above-mentioned advantages.

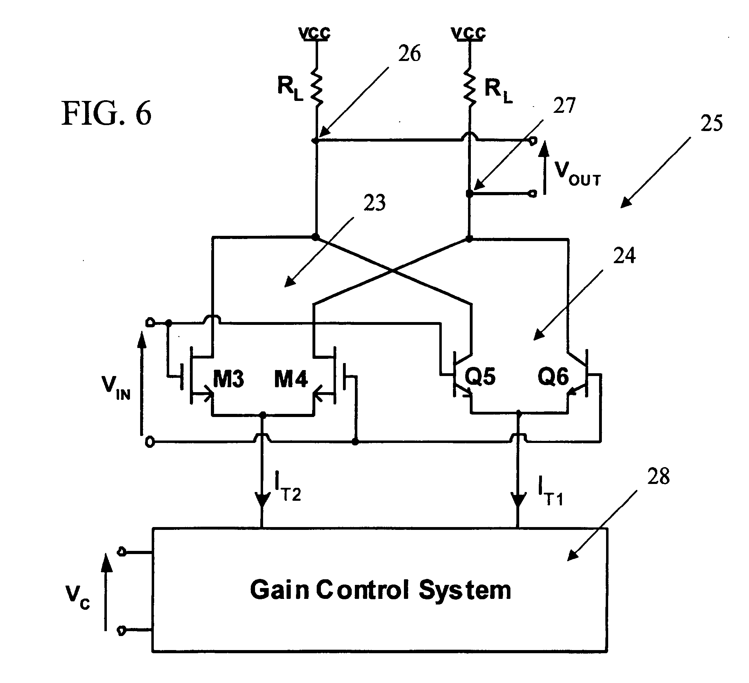

Another possible use of the invention provided is the generation of a bias system effective to keep constant the output dynamic range of a variable gain amplifier 25 of the type shown in figure 6 when the temperature and the process vary.

Variable gain amplifiers 25, of the type shown in figure 6, are used in some typologies of receivers requiring a high gain low noise performance and a low gain high linearity performance. The circuit operation is the following. The two differential couples 23, 24 perform the voltage-current conversion starting from the same input signal $V_{IN}$ thus generating two current differential signals $g_{mMos}.V_{IN}$ and $g_{mBJT}.V_{IN}$ which add on output nodes 26, 27. The current-voltage conversion is performed by two load resistances RL. The voltage gain expression of this amplifier is thus:

$$A_V(I_{T1}, I_{T2}) = [g_{mBJT}(I_{T1}) + g_{mMOS}(I_{T2})].R_L \qquad (24)$$

A control circuit portion 28 provides then to generate the tail currents $I_T1$. and $I_{T2}$ as function r of the control signal $V_c$.

$$(I_{T1}, I_{T2}) = \Gamma(V_C) \qquad (25)$$

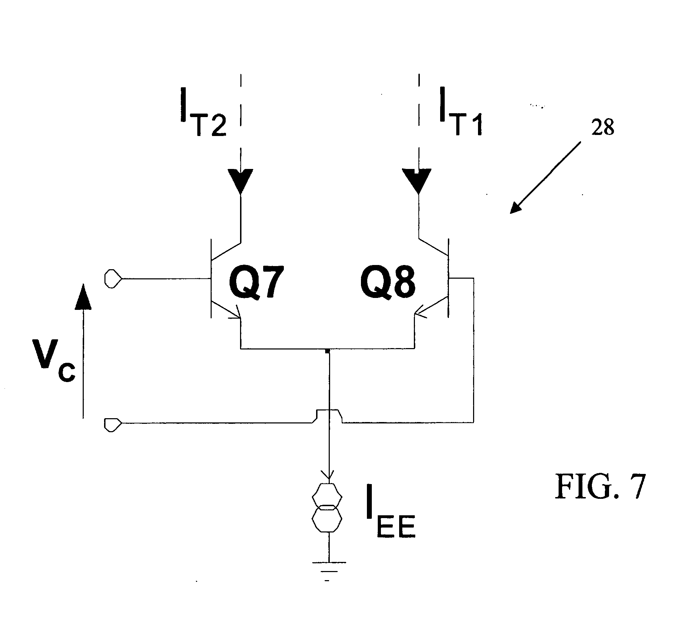

Therefore, once the intervention of the control circuit portion 28 fixed, the amplifier gain is function of the control voltage $V_c$. An embodiment of the control circuit portion 28 which can be used is shown in figure 7.

In such a control circuit 28, which is essentially known, the current $I_{EE}$ is deviated on the output branches according to the control voltage VC, according to the following relation.

$$I_{T1} = \frac{\alpha \cdot I_{EE}}{1 + \exp\left(\dfrac{V_C}{V_T}\right)} \quad , \quad I_{T2} = \alpha \cdot I_{EE} - I_{T1} \qquad (26)$$

Therefore, by using this control circuit 28, under both extreme gain conditions (for vc<<0 and Vc<<0), only a differential couple 23 or 24 is active and biased by the current $\alpha.I_{EE}$.

Supposing that the bipolar couple 24 transconductance is higher than the MOS couple 23 transconductance, the output dynamic range, considered as the ratio between the highest and the lowest gain value, is:

$$\frac{A_{V MAX}}{A_{V MIN}} = \frac{g_{mBJT}}{g_{mMOS}} = \frac{\dfrac{\alpha \cdot I_{EE}}{V_T}}{2\sqrt{K_n \cdot \dfrac{W}{L} \cdot \alpha \cdot I_{EE}}} \qquad (27)$$

Two important limits derive from this latter expression:

- Since both transconductances depend on uncorrelated process parameters the output dynamic range considerably varies with process tolerances.

- The temperature control law applied to the current $I_{EE}$ generation can offset only one of the two transconductances, therefore the output dynamic range will considerably vary with temperature.

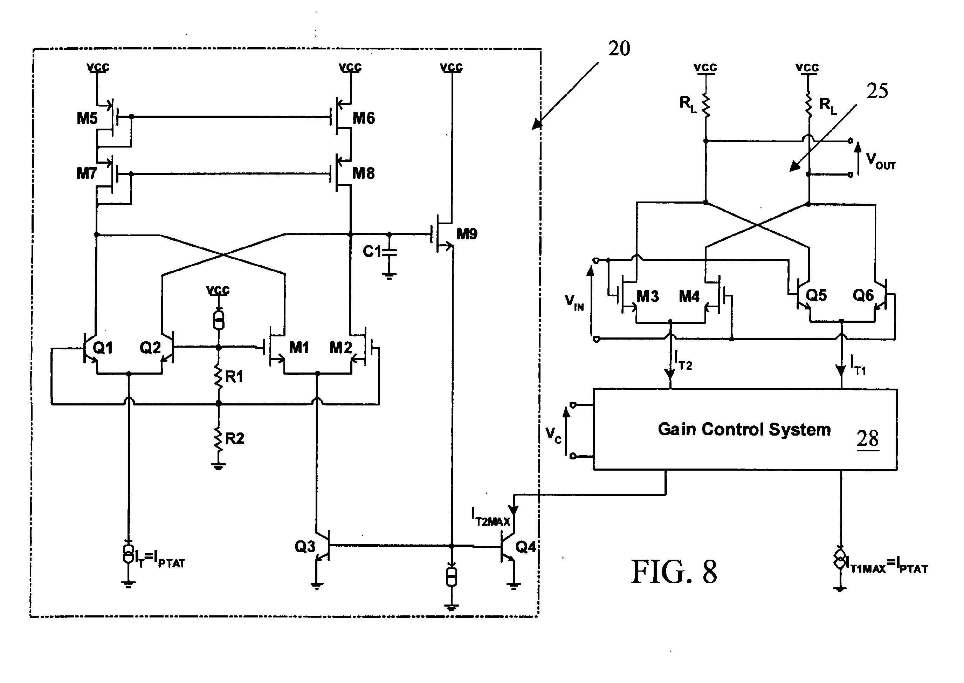

By applying the circuit structure 20 according to the invention according to the scheme of figure 8 both above-mentioned problems can be solved.

The basic idea is to provide the gain control circuit portion 28 with the two bias currents $I_{T1MAX}$ and $I_{T2MAX}$ so that the same control circuit 28 provides them as tail currents to the differential couples Q5-Q6 and M3-M4 under both extreme gain conditions. By applying this scheme to the (22) the expression of the output dynamic range is the following:

$$\frac{A_{V\,MAX}}{A_{V\,MIN}} = \frac{g_{mBJT}}{g_{mMOS}} = \frac{g_{mBJT}}{\gamma \cdot g_{mBJT}} = \frac{1}{\gamma} \qquad (28)$$

where $\gamma$ is a very accurate proportionality factor since it depends only on the ratio between form factors and emitter areas, and it is therefore independent from process and temperature variations. Therefore under these conditions the output dynamic range is very accurate and independent from temperature variations.

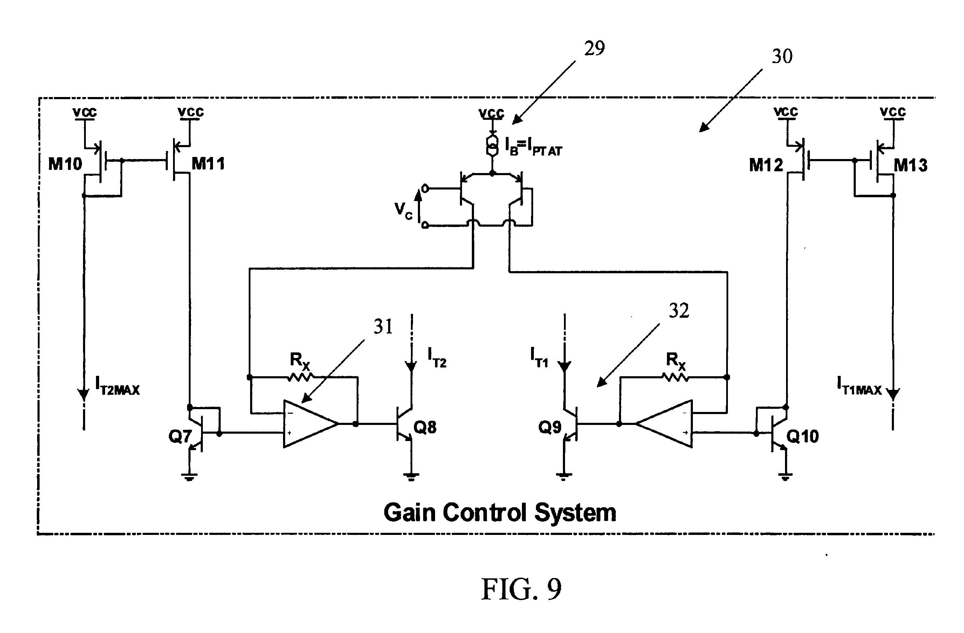

Moreover, by generating the bias currents IT and $I_{T1MAX}$ starting from a PTAT current reference and using a control circuit 30 whose variation law $\Gamma(V_c)$ is independent from the temperature, also the absolute value of the voltage gain (expression (24)) will not depend on the temperature. An example of control circuit 30 is shown in figure 9 wherein a current reference $I_{PTAT}$ can be seen, indicated with 29, to supply respective circuit branches 31, 32 equipped with differential amplifiers arranged to drive respective output transistors Q8, Q9.

A voltage reference obtained from a corresponding bias current $I_{T1MAX}$, $I_{T2MAX}$ is also applied to each amplifier, and by means of a current mirror circuit portion.

The method and the circuit structure according to the invention solve the technical problem and allow the transconductances of at least two different types of transistors to be correlated, independently from process tolerances or temperature and by means of a proportionality coefficient.

**Claims**

1. A method for correlating the transconductance value of transistors of different types, for example MOS transistors and bipolar transistors, wherein the method: - provides a circuit structure (10) comprising a first differential cell (3) formed by transistors (T1a, T1b) of the first type and a second differential cell (4) formed by transistors (T2a, T2b) of the second type;

   - applies to differential inputs of the first (3) and second (4) differential cells, biased through respective current driven generator ($I_M$) and tail current ($I_T$), a constant differential voltage ($\Delta Vd$);
   - draws a current error signal ($\Delta\varepsilon$) related to the difference of the two differential output currents of said first (3) and second (4) differential cells by means of a current mirror circuit portion (6) connecting to each other said first (3) and second (4) differential cells and comprised in said circuit structure (10);
   - applies this current error signal ($\Delta\varepsilon$), via an amplified way (Ao), to an output node (O) of the circuit structure (10) and to a driving terminal of said current driven generator ($I_M$) of said first differential cell (3) in order to obtain feedback inside said circuit structure (10) so that a transconductance correlation between said first (3) and second (4) differential cells is independent from process tolerances and temperature.

2. A method according to claim 1, **characterised in that** the current error signal ($\Delta\varepsilon$) application to said output node (O) of the circuit structure (10) occurs by means of an amplifier.

3. A method according to claim 1, **characterised in that** a current being proportional to said current error signal ($\Delta\varepsilon$) is applied to bias circuit portions (5) of transistors of the first type.

4. A method according to claim 1, **characterised in that** a current is applied on said output node (O) of the circuit structure (10) to bias circuit portions (5) of transistors of the first type by means of a mirror of said tail current ($I_M$).

5. A circuit structure (10) to correlate the transconductance value of transistors of different type, for example MOS transistors and bipolar transistors, comprising a first differential cell (3) formed by transistors (T1a, T1b) of the first type and a second differential cell (4) formed by transistors (T2a, T2b) of the second type connected to each other by means of a current mirror circuit portion (6), wherein current mirror circuit portion (6) is configured for calculating a current error signal ($\Delta\varepsilon$) as difference between the two differential output currents of said first (3) and second (4) differential cells, which are biased through respective current driven generator ($I_M$) and tail current ($I_T$), a constant differential voltage ($\Delta V_d$) being applied to differential inputs of the first(3) and second (4) differential cells, and for applying said current error signal, via an amplified way (Ao), to an output node (O) of the circuit structure (10) and to a driving terminal of said current driven generator ($I_M$) of said first differential cell (3) in order to obtain feedback inside said circuit structure (10)so that a transconductance correlation between said first (3) and second (4) differential cell is independent from process tolerances and temperature.

6. A circuit structure (10) according to claim 5, **characterised in that** said first differential cell (3) is connected to a first potential reference (GND) by means of said current driven generator ($I_M$).

7. A circuit structure (10) according to claim 6, **characterised in that** a current being proportional to said current error signal ($\Delta\varepsilon$) is applied to bias circuit portions (5) comprising transistors of the same type of said first differential cell (3).

8. A circuit structure (20) according to claim 6, **characterised in that** the first differential cell (13) comprises MOS transistors and the second differential cell (14) comprises bipolar transistors and **in that** said first and second differential cells (13, 14) are connected to each other by means of a cascode-connected current mirror circuit portion (16).

9. A circuit structure (20) according to claim 8, **characterised in that** said current mirror circuit portion (16) comprises MOS transistors (M5-M8).

10. A circuit structure (20) according to claim 8, **characterised in that** said current mirror circuit portion (16) comprises bipolar transistors.

11. A circuit structure (20) according to claim 8, **characterised in that** said current driven generator ($I_M$) is a bipolar transistor (Q3) connected to the first differential cell (13).

12. A circuit structure (20) according to claim 8, **characterised in that** both current generators driven by the output node (O) are MOS transistors.

13. A circuit structure (20) according to claim 5, **characterised in that** said amplifier is a MOS transistor (M9).

14. A circuit structure (20) according to claim 8, **characterised in that** said current being proportional to said error signal ($\Delta\varepsilon$) is coupled to a variable gain amplifier (25) equipped with a gain control circuit portion (28).

15. A circuit structure (20) according to claim 14, **characterised in that** a bias current generated by said circuit structure (20) is provided to said gain control circuit portion (28).

**Patentansprüche**

1. Verfahren zum Korrelieren des Transkonduktanzwertes von Transistoren unterschiedlichen Typs, beispielsweise von MOS-Transistoren und bipolaren Transistoren, wobei das Verfahren:

- eine eine durch Transistoren (T1a, T1b) des ersten Typs gebildete erste Differentialzelle (3) und eine durch Transistoren (T2a, T2b) des zweiten Typs gebildete zweite Differentialzelle (4) aufweisende Schaltungsstruktur (10) vorsieht,
- auf durch einen stromgesteuerten Generator ($I_M$) und durch einen Schwanzstrom ($I_T$) mit einer konstanten Differentialspannung ($\Delta V_d$) vorgespannte Differentialeingänge der ersten (3) beziehungsweise der zweiten (4) Differentialzelle abstellt;
- mittels eines Stromspiegelteilbereiches (6), welcher die erste Differentialzelle (3) und die zweite Differentialzelle (4) miteinander verbindet und in der Schaltungsstruktur (10) enthalten ist, ein Stromfehlersignal ($\Delta\varepsilon$) zieht, welches auf die Differenz der beiden Differentialaufgangsströme der ersten (3) und zweiten (4) Differentialzelle bezogen ist;
- dieses Stromfehlersignal ($\Delta\varepsilon$) über einen verstärkten Weg (Ao) auf einen Ausgangsknoten der Schaltungsstruktur (10) und auf einen Ansteueranschluss des stromgesteuerten Generators (IM) der ersten Differentialzelle (3) aufbringt, um eine Rückkopplung innerhalb der Schaltungsstruktur (10) zu erzielen, so dass eine Transkonduktanz-Korrelation zwischen der ersten Differentialzelle (3) und der zweiten Differentialzelle (4) unabhängig von Prozeßtoleranzen und der Temperatur wird.

**2.** Verfahren nach Anspruch 1, **dadurch gekennzeichnet, dass** das Aufbringen des Stromfehlersignals ($\Delta\varepsilon$) auf den Ausgangsknoten (O) der Schaltungsstruktur (10) mittels eines Verstärkers geschieht.

**3.** Verfahren nach Anspruch 1, **dadurch gekennzeichnet, dass** ein dem Stromfehlersignal ($\Delta\varepsilon$) proportionaler Strom aufgebracht wird, um Schaltungsteilbereiche (5) von Transistoren des ersten Typs vorzuspannen.

**4.** Verfahren nach Anspruch 1, **dadurch gekennzeichnet, dass** auf den Ausgangsknoten (O) der Schaltungsstruktur (10) ein Strom aufgebracht wird, um Schaltungsteilbereiche (5) von Transistoren des ersten Typs mittels eines Spiegels des Schwanzstromes ($I_M$) vorzuspannen.

**5.** Schaltungsstruktur (10) zum Korrelieren des Transkonduktanzwertes von Transistoren unterschiedlichen Typs, beispielsweise MOS-Transistoren und Bipolartransistoren, aufweisend
eine erste Differentialzelle (3), gebildet durch Transistoren (T1a, T1b) des ersten Typs und eine zweite Differentialzelle (4), gebildet durch Transistoren (T2a, T2b) des zweiten Typs, die mittels eines Stromspiegelschaltungsteilbereichs (6) miteinander verbunden sind,
wobei der Stromspiegelschaltungsteilbereich (6) konfiguriert ist zum Berechnen eines Stromfehlersignals ($\Delta\varepsilon$) als einer Differenz zwischen den beiden Differentialausgangsströmen der ersten Differentialzelle (3) und der zweiten Differentialzelle (4), welche durch einen stromgesteuerten Generator ($I_M$) beziehungsweise durch einen Schwanzstrom ($I_T$) vorgespannt sind, wobei eine konstante Differentialspannung ($\Delta V_d$) auf die Differentialeingänge der ersten Differentialzelle (3) und der zweiten Differentialzelle (4) aufgebracht wird, und zum Aufbringen des Stromfehlersignals über einen verstärkten Weg (Ao) auf einen Ausgangsknoten (O) der Schaltungsstruktur (10) und auf einen Ansteueranschluss des stromgesteuerten Generators ($I_M$) der ersten Differentialzelle (3), um innerhalb der Schaltungsstruktur (10) eine Rückkopplung zu erzielen, so dass eine Transkonduktanzkorrelation zwischen der ersten Differentialzelle (3) und der zweiten Differentialzelle (4) unabhängig von Prozesstoleranzen und Temperatur ist.

**6.** Schaltungsstruktur (10) nach Anspruch 5, **dadurch gekennzeichnet, dass** die erste Differentialzelle (3) mittels des stromgesteuerten Generators (IM) mit einem ersten Bezugspotential (GND) verbunden ist.

**7.** Schaltungsstruktur (10) nach Anspruch 6, **dadurch gekennzeichnet, dass** ein zu dem Stromfehlersignal ($\Delta\varepsilon$) proportionaler Strom aufgebracht wird, um Schaltungsteilbereiche (5) vorzuspannen, welche Transistoren desselben Typs wie die erste Differentialzelle (3) umfassen.

**8.** Schaltungsstruktur (20) nach Anspruch 6, **dadurch gekennzeichnet, dass** die erste Differentialzelle (13) MOS-Transistoren umfasst und dass die zweite Differentialzelle (14) bipolare Transistoren umfasst und dass die erste Differentialzelle (13) und die zweite Differentialzelle (14) mittels einem kaskodenverbundenen Stromspiegelschaltungsteilbereich (16) miteinander verbunden sind.

**9.** Schaltungsstruktur (20) nach Anspruch 8, **dadurch gekennzeichnet, dass** der Stromspiegelschaltungsteilbereich (16) MOS-Transistoren (M5-M8) umfasst.

**10.** Schaltungsstruktur (20) nach Anspruch 8, **dadurch gekennzeichnet, dass** der Stromspiegelschaltungsteilbereich (16) Bipolartransistoren umfasst.

**11.** Schaltungsstruktur (20) nach Anspruch 8, **dadurch gekennzeichnet, dass** der stromgesteuerte Generator ($I_M$) ein mit der ersten Differentialzelle (13) verbundener Bipolartransistor (Q3) ist.

**12.** Schaltungsstruktur (20) nach Anspruch 8, **dadurch gekennzeichnet, dass** beide Stromgeneratoren, die durch den Ausgangsknoten (O) angesteuert werden, MOS-Transistoren sind.

**13.** Schaltungsstruktur (20) nach Anspruch 5, **dadurch gekennzeichnet, dass** der Verstärker ein MOS-Transistor (M9) ist.

**14.** Schaltungsstruktur (20) nach Anspruch 8, **dadurch gekennzeichnet, dass** der dem Fehlersignal ($\Delta\varepsilon$) proportionale Strom mit einem Verstärker mit variablen Verstärkungsfaktor (25) gekoppelt ist, der mit einem Verstärkungssteuerungsschaltungsteilbereich (28) ausgerüstet ist.

15. Schaltungsstruktur (20) nach Anspruch 14, **dadurch gekennzeichnet, dass** der durch die Schaltungsstruktur (20) erzeugte Vorspannungsstrom an den Verstärkungssteuerungsschaltungsteilbereich (28) geliefert wird.

**Revendications**

1. Procédé de corrélation de la valeur de transconductance de transistors de différents types, par exemple des transistors MOS et des transistors bipolaires dans lequel le procédé comprend des étapes consistant à :

   - prévoir une structure de circuit (10) comprenant une première cellule différentielle (3) formée par des transistors (T1a, T1b) du premier type et une seconde cellule différentielle (4) formée par des transistors (T2a, T2b) du second type,
   - appliquer à des entrées différentielles de la première (3) et de la seconde (4) cellule différentielle, respectivement polarisées par l'intermédiaire d'un générateur de courant piloté (IM) et d'un courant de queue (IT), une tension différentielle constante ($\Delta Vd$),
   - tirer un signal d'erreur de courant ($\Delta\varepsilon$) en relation avec la différence des deux courants de sortie différentielle de la première (3) et de la seconde (4) cellule différentielle au moyen d'une partie de circuit en miroir de courant (6) connectant l'une à l'autre la première (3) et la seconde (4) cellule différentielle et compris dans la structure de circuit (10),
   - appliquer ce signal d'erreur de courant ($\Delta\varepsilon$) par un moyen amplifié (Ao), sur un noeud de sortie (O) de la structure de circuit (10) et sur une borne de pilotage du générateur de courant piloté (IM) de la première cellule différentielle (3) afin d'obtenir une rétroaction dans la structure de circuit (10) de telle sorte qu'une corrélation de transconductance entre la première (3) et la seconde (4) cellule différentielle est indépendante des tolérances et de la température de traitement.

2. Procédé selon la revendication 1, **caractérisé en ce que** l'application du signal d'erreur de courant ($\Delta\varepsilon$) sur le noeud de sortie (0) de la structure de circuit (10) est effectuée au moyen d'un amplificateur.

3. Procédé selon la revendication 1, **caractérisé en ce qu'**un courant proportionnel au signal d'erreur de courant ($\Delta\varepsilon$) est appliqué aux parties de circuit polarisées (5) de transistors du premier type.

4. Procédé selon la revendication 1, **caractérisé en ce qu'**un courant est appliqué sur le noeud de sortie (O) de la structure de circuit (10) afin de polariser des parties de circuit (5) de transistors du premier type au moyen d'un miroir du courant de queue (IM) .

5. Structure de circuit (10) permettant de corréler la valeur de transconductance de transistors de différents types, par exemple des transistors MOS et des transistors bipolaires, comprenant une première cellule différentielle (3) formée par des transistors (T1a, T1b) du premier type et une seconde cellule différentielle (4) formée par des transistors (T2a, T2b) du second type connectés les uns aux autres au moyen d'une partie de circuit en miroir de courant (6), dans laquelle la partie de circuit en miroir de courant (6) est configurée pour calculer un signal d'erreur de courant ($\Delta\varepsilon$) comme différence entre les deux courants de sortie différentielle de la première (3) et de la seconde (4) cellule différentielle, qui sont respectivement polarisées par l'intermédiaire d'un générateur de courant piloté (IM) et d'un courant de queue (IT), une tension différentielle constante ($\Delta Vd$) étant appliquée aux entrées différentielles de la première (3) et de la seconde (4) cellule différentielle, et pour appliquer le signal d'erreur de courant, par un moyen amplifié (Ao), sur un noeud de sortie (O) de la structure de circuit (10) et sur une borne de pilotage du générateur de courant piloté (IM) de la première cellule différentielle (3) afin d'obtenir une rétroaction dans la structure de circuit (10) de telle sorte qu'une corrélation de transconductance entre la première (3) et la seconde (4) cellule différentielle est indépendante des tolérances et de la température de traitement.

6. Structure de circuit (10) selon la revendication 5, **caractérisée en ce que** la première cellule différentielle (3) est connectée à une première référence de potentiel (GND) au moyen d'un générateur de courant piloté (IM).

7. Structure de circuit (10) selon la revendication 6, **caractérisée en ce qu'**un courant proportionnel au signal d'erreur de courant ($\Delta\varepsilon$) est appliqué aux parties de circuit polarisées (5) comprenant des transistors du même type que la première cellule différentielle (3).

8. Structure de circuit (20) selon la revendication 6, **caractérisée en ce que** la première cellule différentielle (13) comprend des transistors MOS et la seconde cellule différentielle (14) comprend des transistors bipolaires et **en ce que** la première et la seconde cellule différentielle (13, 14) sont connectées l'une à l'autre au moyen d'une partie de circuit en miroir de courant connectée en cascode (16).

9. Structure de circuit (20) selon la revendication 8, **caractérisée en ce que** la partie de circuit en miroir de courant (16) comprend des transistors MOS (M5-M8).

10. Structure de circuit (20) selon la revendication 8, **caractérisée en ce que** la partie de circuit en miroir de courant (16) comprend des transistors bipolaires.

11. Structure de circuit (20) selon la revendication 8, **caractérisée en ce que** le générateur de courant piloté (IM) est un transistor bipolaire (Q3) connecté à la première cellule différentielle (13).

12. Structure de circuit (20) selon la revendication 8, **caractérisée en ce que** les deux générateurs de courant pilotés par le noeud de sortie (O) sont des transistors MOS.

13. Structure de circuit (20) selon la revendication 5, **caractérisée en ce que** l'amplificateur est un transistor MOS (M9).

14. Structure de circuit (20) selon la revendication 8, **caractérisée en ce que** le courant proportionnel au signal d'erreur de courant ($\Delta\epsilon$) est couplé à un amplificateur de gain variable (25) équipé d'une partie de circuit de contrôle de gain (28).

15. Structure de circuit (20) selon la revendication 14, **caractérisée en ce qu'**un courant de polarisation généré par la structure de circuit (20) est fourni à la partie de circuit de contrôle de gain (28).

FIG. 1

FIG. 2

EP 1 494 351 B1

FIG. 3

EP 1 494 351 B1

FIG. 4

FIG. 5

EP 1 494 351 B1

FIG. 6

FIG. 7

FIG. 8

EP 1 494 351 B1

**Gain Control System**

FIG. 9

EP 1 494 351 B1

**EP 1 494 351 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2369508 A